Europäisches Patentamt

European Patent Office

Office européen des brevets

(11) Publication number: 0 401 031
A2

# EUROPEAN PATENT APPLICATION

(21) Application number: 90305982.2

(51) Int. Cl.⁵: H01L 39/24

(22) Date of filing: 31.05.90

The title of the invention has been amended (Guidelines for Examination in the EPO, A-III, 7.3).

(30) Priority: 31.05.89 JP 138884/89
15.06.89 JP 152947/89
29.09.89 JP 254941/89

(43) Date of publication of application:
05.12.90 Bulletin 90/49

(84) Designated Contracting States:
DE FR GB

(71) Applicant: Kabushiki Kaisha Toshiba
72, Horikawa-cho Saiwai-ku
Kawasaki-shi(JP)

(72) Inventor: Eguchi, Kazuhiro, c/o Intellectual
Property Div.
Kabushiki Kaisha Toshiba 1-1 Shibaura
1-chome
Minato-ku Tokyo 105(JP)
Inventor: Nakanisi, Takatosi

Deceased(JP)
Inventor: Satoh, Rie c/o Intellectual Property
Div.
Kabushiki Kaisha Toshiba 1-1 Shibaura
1-chome
Minato-ku Tokyo 105(JP)

(74) Representative: Freed, Arthur Woolf et al
MARKS & CLERK 57-60 Lincoln's Inn Fields
London WC2A 3LS(GB)

(54) Oxide thin film and method of epitaxially growing same.

(57) A method of epitaxially growing a crystalline oxide thin film, comprising the steps of loading a substrate (11, 23) in a reaction vessel (21), epitaxially growing as an underlying film a crystalline thin film (12) essentially consisting of the same material as that of the substrate on the substrate, and changing a source gas to epitaxially grow a desired crystalline oxide thin film (13) on the underlying film.

F I G. 1

## Oxide thin film base and method of epitaxially growing oxide thin film

The present invention relates to an oxide thin film base and a method of epitaxially growing an oxide thin film.

In recent years, oxide superconductors exhibiting superconductive characteristics at high temperatures have received a great deal of attention. As a typical oxide superconductor, $YBa_2Cu_3O_{7-\delta}$ and a superconductor obtained by partially substituting Y of $YBa_2Cu_3O_{7-\delta}$ by a lanthanum element (to be referred to as YBaCuO hereinafter) are well known. Bismuth systems (to be referred to as BiSr-CaCuO hereinafter) such as $Bi_2Sr_2CaCu_2O_x$ and $Bi_2Sr_2Ca_2Cu_3O_y$ are expected as promising materials. Since the critical temperature $T_c$ of these oxide superconductors exceeds 100 K, the oxide superconductors are employed in a variety of applications for high-speed logic devices operated at a liquid nitrogen temperature (77 K).

In order to industrially use these oxide superconductors, the oxide crystal thin films must be formed with a controlled composition, few defects, and excellent reproducibility. In particular, in order to apply an oxide superconductor to a high-speed logic device, a flat singlecrystalline thin film must be formed.

As a conventional method of forming the oxide superconductor thin film, metalorganic chemical vapor depostion (MOCVD) which is one type of chemical vapor deposition (CVD) methods using an organic metal has been extensively studied as a promising method. According to the MOCVD, amounts of source gases of elements consisting of a desired oxide superconductor can be independently and precisely controlled. In this case, crystalline $SrTiO_3$ and MgO substrates which have relatively good lattice matching with respect to the oxide superconductor and coefficients of thermal expansion close to the oxide superconductor have been used. When a YBaCuO superconductor thin film is grown on the $SrTiO_3$ substrate, it is reported that the YBaCuO thin film exhibits superconductive characteristics in the growth temperature of 800 °C or more. The thin film is grown such that the (001) plane of the thin film is parallel to the (001) plane of the $SrTiO_3$ substrate. That is, the thin film exhibits so-called c-axis orientation.

However, all the YBaCuO oxide superconductor thin films obtained on the $SrTiO_3$ substrate are polycrystalline, and the surface flatness of the thin film surface is poor. This is because the thin film has unevenness of the substrate surface and lattice defects. In particular, before deposition of the film, crystalline components on the substrate surface are decomposed by substrate heating at a high temperature to discharge oxygen. Therefore, it is understood that flatness of the substrate surface is degraded, and lattice defects are increased. Therefore, a practical logic element cannot be formed using such a thin film.

An MgO substrate is selected because its coefficient of thermal expansion is close to that of an oxide superconductor. However, when a BiSr-CaCuO oxide superconductor thin film is formed on the (001) plane of the MgO crystal, only a polycrystalline oxide superconductor thin film having poor flatness can be obtained.

Besides the above literatures, it is reported that the YBaCuO superconductor thin film is formed using a crystalline $LaGaO_3$ substrate. This substrate has relatively good lattice matching with respect to YBaCuO and a coefficient of thermal expansion close to YBaCuO. However, the resultant thin film is not singlecrystalline, and the substrate surface is uneven.

As described above, in order to employ the oxide superconductor to an electric device, an oxide superconductor thin film having high quality is expected. However, a singlecrystalline oxide superconductor thin film having an excellent flat surface is not obtained.

It is well known that an Si wafer whose surface is covered with a fluoride thin film of Group II element which does not contain oxygen is used as a substrate. For example, a $BaF_2$ thin film is deposited on an Si substrate as a buffer layer, and a YBCO thin film is deposited on the resultant structure by MOCVD, as disclosed in Appl. Phys. Lett. journal vol. 54 (1989) pp. 2479 - 2480. It is reported that reaction between the YBCO thin film and Si is controlled to largely improve superconductive characteristics by this structure. In this case, the $BaF_2$ thin film is formed by depositing a $BaF_2$ crystal on the Si substrate in a high vacuum.

In the conventional example described above, the step of depositing the $BaF_2$ thin film on the Si substrate is performed by vacuum evaporation. The Si substrate deposited with the $BaF_2$ thin film is unloaded from a vacuum evaporation apparatus, and this substrate is then loaded in an MOCVD reaction furnace again to deposit a YBCO oxide superconductor thin film. According to this method, different types of thin film deposition apparatuses are used to result in a cumbersome operation. In addition, the substrate is repeated heated and kept at high temperatures, and the thermal hysteresis becomes complicated. Cracks tend to be formed between the substrate and the YBCO thin film by the stress generated between the substrate and the YBCO thin film. In addition, since the substrate is unloaded from the deposition apparatus and is exposed to the outer air, the clean surface of the $BaF_2$ thin film deposited on the Si substrate in a clean state adsorbs moisture and other active impurities and is contaminated. As a result, the nature of, e.g., the YBCO thin film crystal deposited on the substrate becomes unstabilized.

In the conventional method, in formation of a high-temperature oxide superconductor thin film on an Si substrate by an MOCVD method, when a growth temperature is low, superconductive characteristics cannot be exhibited. To the contrary, when a growth temperature and a post-annealing temperature are excessively high, the flatness of the thin film surface is degraded. In addition, since different types of deposition apparatuses are used, the operations become cumbersome, and the substrate tend to be contaminated.

It is a first object of the present invention to provide a singlecrystalline oxide thin film base having excellent surface flatness.

It is a second object of the present invention to provide a method of epitaxially growing a singlecrystalline oxide thin film having excellent surface flatness.

It is a third object of the present invention to provide an oxide thin film base having excellent surface flatness and formed on a semiconductor substrate.

It is a fourth object of the present invention to provide a method of manufacturing an oxide thin film having excellent surface flatness on a semiconductor substrate by an MOCVD method while contamination of the semiconductor substrate during the process can be reduced.

In order to achieve the first and second objects of the present invention, when a substrate is loaded in a reaction vessel to epitaxially grow a crystalline oxide thin film on the substrate while a source gas is supplied to the reaction vessel, a crystalline thin film consisting of the same material as that of the substrate is epitaxially grown as an underlying layer on the substrate, and the source gas is changed to epitaxially grow a desired crystalline oxide thin film.

According to the present invention, a thin film consisting of the same crystal as that of the substrate is deposited on the surface of the substrate immediately prior to deposition of the desired crystalline oxide thin film. Unlike in the conventional process, the substrate is not exposed to a high temperature in a state wherein a desired crystalline oxide thin film is not deposited. As a result, degradation of flatness of the substrate or an increase in crystal defects can be prevented. Therefore, a singlecrystalline oxide thin film having excellent flatness can be obtained.

The first and second objects of the present invention are achieved by using a substrate, at least a surface portion of which consists of an $LaGa_xAl_{1-x}O_3$ $(0 < x < 1)$ crystal, when a YBaCuO or BiSrCaCuO oxide thin film is epitaxially grown.

More specifically, when a substrate is loaded in a reaction vessel to epitaxially grow a YBaCuO or BiSrCaCuO oxide thin film on the substrate while a source gas is supplied to the reaction vessel, a crystalline $LaGa_xAl_{1-x}O_3$ $(0 < x < 1)$ oxide thin film is formed, and then the source gas is changed to grow the desired oxide thin film.

According to the present invention, since the $LaGa_xAl_{1-x}O_3$ $(0 < x < 1)$ film as the underlying film is formed by crystal growth, a singlecrystalline YBaCuO or BiSrCaCuO oxide thin film having excellent flatness can be obtained.

The fourth object of the present invention is achieved as follows. A buffer layer is formed between a semiconductor substrate and an oxide (high-temperature superconductor) thin film by an MOCVD method. In addition, semiconductor substrate temperatures, types of gas, gas flow rates, and the like before and after formation of the buffer layer are optimized.

More specifically, according to the present invention, there is provided a method of manufacturing an oxide thin film by supplying a predetermined gas to a reaction furnace in which a semiconductor substrate is loaded, thereby depositing the oxide thin film on the substrate by an epitaxial growth method. In this case, the substrate consists of GaAs. The GaAs substrate is heated to a temperature for depositing an oxide thin film while a gas (e.g., $AsH_3$) containing arsenic is supplied to the reaction furnace. After supply of the gas containing arsenic to the reaction furnace is stopped, an organic metal compound source gas containing fluorine and a metal element of, e.g., Group II is supplied to the reaction furnace to deposit a buffer layer consisting of a metal fluoride thin film crystal (e.g., $CaF_2$) on the GaAs substrate. An organic metal compound source gas containing oxygen and a metal element for an oxide thin film to be formed is supplied to the reaction furnace, thereby forming the desired oxide thin film on the buffer layer.

According to the present invention, there is also provided a method of manufacturing an oxide thin film by supplying a predetermined gas to a reaction furnace in which a semiconductor substrate is loaded, thereby depositing the oxide thin film on the substrate by an epitaxial growth method. In this case, the semiconductor substrate consists of GaP or InP. The substrate is heated to a temperature for depositing an oxide thin film while a gas (e.g., $PH_3$) containing phosphorus is supplied to the reaction furnace. After supply of the gas containing phosphorus to the reaction furnace is stopped, an organic metal compound source gas containing fluorine and a metal element of, e.g., Group II is supplied to deposit a buffer layer consisting of a metal fluoride thin film crystal on the substrate. A gas containing oxygen and an organic metal compound source gas containing a metal element for a desired oxide thin film is supplied to deposit a desired oxide thin film on the buffer layer.

According to the present invention, there is also provided a method of manufacturing an oxide thin film by supplying a predetermined gas to a reaction furnace in which a semiconductor substrate is loaded, thereby depositing the oxide thin film on the substrate by an epitaxial growth method. In this case, the substrate consists of silicon. The silicon substrate is heated to a temperature or more for depositing a metal fluoride in a hydrogen flow while a gas containing hydrogen is supplied to the reaction furnace. After supply of the gas containing hydrogen to the reaction furnace is stopped, an organic metal compound source gas containing fluorine and a metal element is supplied to the reaction furnace to deposit a buffer layer consisting of a metal fluoride thin film crystal on the silicon substrate. A gas containing oxygen and an organic metal compound source gas containing a metal element for a desired oxide thin film is supplied to form the desired oxide thin film on the buffer layer.

The third object of the present invention is achieved by an oxide thin film base comprising a semiconductor substrate, a buffer layer consisting of a fluoride thin film crystal epitaxially grown on the semiconductor substrate, and an oxide thin film formed on the buffer layer.

When the GaAs substrate is heated to the temperature for depositing an oxide (high-temperature superconductor) thin film, a gas such as an $AsH_3$ gas is supplied to the reaction furnace. After supply of this gas to the reaction furnace is stopped, the fluoride (e.g., $CaF_2$) buffer layer is deposited on the substrate. Therefore, the surface of the GaAs substrate is not degraded during heating. In addition, since the fluoride buffer layer which does not contain oxygen is deposited on the substrate surface, the desired oxide thin film having a flat surface can be formed.

GaAs as one of the Group III-V compound semiconductors free from crystal defects has a cubic crystal structure, and its formation method is industrially established. When GaAs is used, a wafer having a relatively large surface area can be obtained. Utilization of a wafer having a large surface area is very important to increase a production yield, decrease the cost, and achieve uniformity in quality when high-speed electronic elements are manufactured. In addition, the GaAs wafer has a very small number of crystal defects since a temperature for forming GaAs is lower than that of an oxide. However, when a GaAs wafer is heated to a temperature for depositing an oxide thin film, arsenic as a Group V element which tends to be evaporated is dissociated and decomposed to denature the surface of the GaAs wafer. In addition, an oxide thin film is directly formed on the denatured GaAs substrate, the thin film is denatured by an alloying reaction. According to the present invention, these problems are solved by supply of the $AsH_3$ gas and deposition of the $CaF_2$ buffer layer immediately after stop of the gas supply.

Formation of a fluoride generally exhibits a lower free energy level than that of an oxide. A fluoride of a metal element from Group II of the Periodic Table is not oxidized by an oxidant when an oxide thin film is formed. Therefore, the fluoride has advantages in that itself is not denatured and it does not denature a desired oxide thin film. When a GaAs substrate having a large surface area is used, the problem resulting from a small fluoride substrate area can be solved. In addition, when a metal fluoride is used to form a buffer layer, degradation of the oxide thin film formed thereon can also be prevented.

Since both the oxide thin film and the buffer layer are formed by an MOCVD method, the same epitaxial growth apparatus used in formation of the oxide thin film can be used in formation of the buffer layer. Therefore, the buffer layer and the oxide thin film can be continuously formed by a single reaction furnace, thereby minimizing substrate contamination. The present invention can be effectively applied to the manufacture of a high-performance electronic device or a superconductor wire. In addition, when the present invention is applied to the manufacture of an insulative oxide thin film in addition to formation of a high-temperature oxide superconductor thin film, an oxide waveguide can be effectively formed.

Even if GaP, InP or Si is used as a material for the substrate, this material has a cubic crystal structure as in GaAs, and its manufacturing method is established on the industrial basis. A wafer having a relatively large area can be advantageously formed. As in the manufacture using GaAs, the product yield can be increased, the manufacturing cost can be reduced, and the uniform quality of the products can be obtained. When GaP or InP is used in place of GaAs, and a gas such as a $PH_3$ gas is used in place of an $AsH_3$ gas during heating of the substrate, degradation of the substrate surface can be prevented during heating. Similarly, when Si is used, hydrogen gas is supplied during heating of the substrate, thereby preventing degradation of the substrate surface. Even when GaP, InP or Si is used as a material for forming a substrate, the methods of forming the buffer layer and the oxide thin film are the same as in the method using GaAs. Therefore, an oxide thin film having a flat surface can be formed.

This invention can be more fully understood from the following detailed description when taken in conjunction with the accompanying drawings, in which:

Fig. 1 is a sectional view showing a deposition state of the BiSrCaCuO oxide superconductor thin film according to the first example of the present invention;

Fig. 2 is a view showing an arrangement of an MOCVD apparatus used in formation of a thin film of the first example;

Fig. 3 is a sectional view showing a deposition state of a BiSrCaCuO oxide superconductor thin film according to the second example;

Fig. 4 is a view showing an arrangement of an MOCVD apparatus used in formation of the thin film;

Fig. 5 is a sectional view showing a deposition state of a YBaCuO oxide superconductor thin film according to the third example of the present invention;

Fig. 6 is a schematic view showing an epitaxial growth apparatus used in the fourth example of the present invention;

Fig. 7 is a sectional view showing a deposition state of a BiSrCaCuO oxide superconductor thin film according to the fourth example;

Fig. 8 is a graph showing variations in substrate temperature and flow rate of a gas according to the fourth example of the present invention;

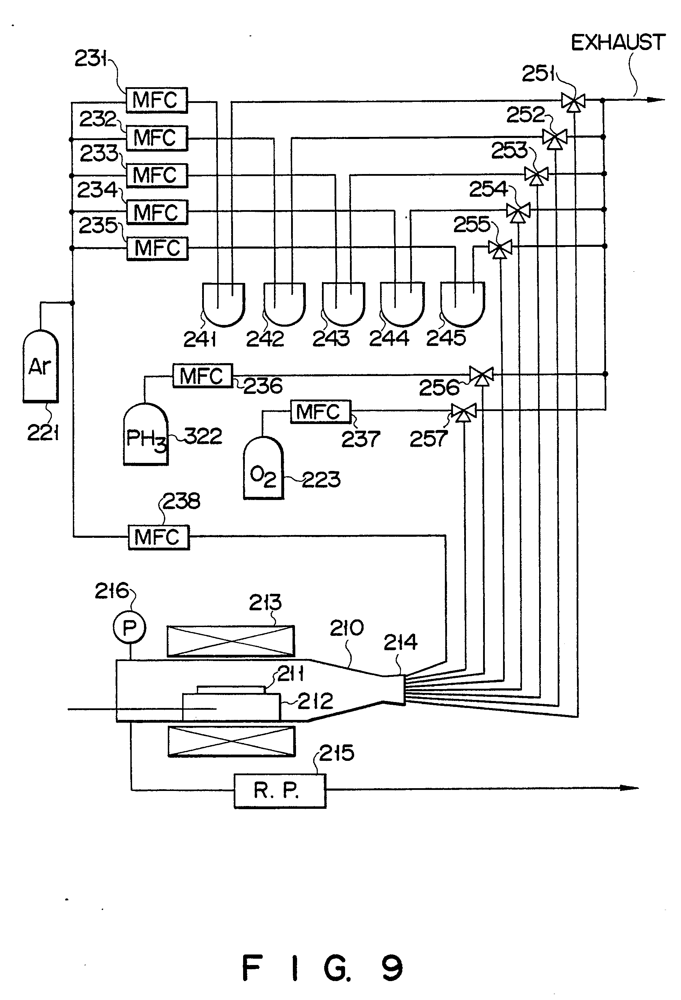

Fig. 9 is a schematic view showing an epitaxial growth apparatus used in the seventh example of the present invention; and

Fig. 10 is a schematic view showing an epitaxial growth apparatus used in the eighth example of the present invention.

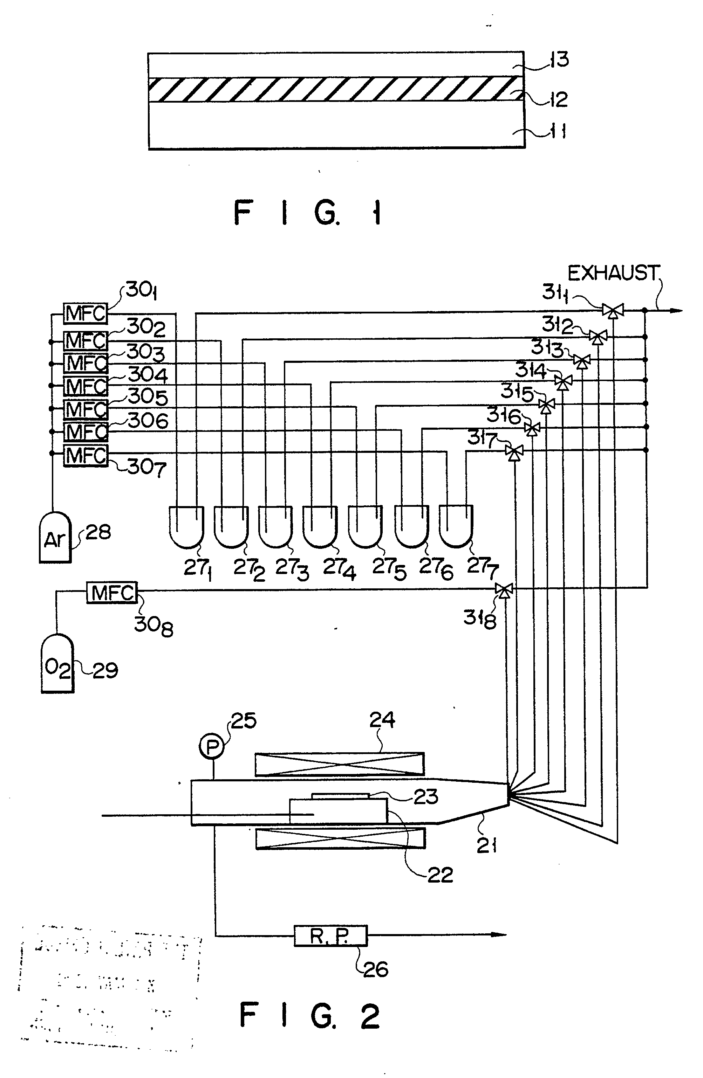

An oxide thin film substrate according to the first example of the present invention will be described with reference to Fig. 1. A crystalline MgO thin film 12 is formed as an underlying film by MOCVD on a substrate 11 which is a singlecrystalline MgO substrate, and a BiSrCaCuO oxide superconductor thin film 13 is continuously formed on the film 12.

Fig. 2 shows an MOCVD apparatus used in this example. This apparatus is constituted by a reaction vessel 21 and an electric furnace 24. A substrate 23 is put on a suscepter 22 in the reaction vessel 21. The suscepter 22 is formed by covering a graphite surface with silicon carbide. Reference numerals 25 and 26 denote a pressure gauge and a vacuum pump, respectively. Organic metal sources are stored in source vessels $27_1$ to $27_7$, and source gases are supplied from the vessels as needed. That is, an Ar gas supplied from an Ar gas cylinder 28 is controlled by mass-flow controllers

$30_1$ to $30_7$ and supplied to the source vessels $27_1$ to $27_7$. Thus, the source gases fed from the source vessels are supplied to the reaction vessel 21 through three-way valves $31_1$ to $31_7$. The flow rate of an $O_2$ gas is controlled by a mass-flow controller $30_8$ to be guided to the reaction vessel 21 through an $O_2$ gas cylinder and a three-way valve $31_8$. The mass-flow controllers $30_1$ to $30_8$ and the three-way valves $31_1$ to $31_8$ are controlled by a sequence controller. An opening/closing timing and a holding time of each of the three-way valves $31_1$ to $31_8$ can be programmed in advance.

An organic metal source for magnesium (Mg) is $Mg(C_{11}H_{19}O_2)_2$, i.e., $Mg(DPM)_2$. Organic metal sources for bismuth (Bi), strontium (Sr), calcium (Ca), and copper (Cu) are $Bi(C_6H_5)_3$, i.e., $Bi(Ph)3$, $Sr(C_{11}H_{19}O_2)_2$, i.e., $Sr(DPM)_2$, $Ca(C_{11}H_{19}O_2)_2$, i.e., $Ca(DPM)_2$, and $Cu(C_{11}H_{19}O_2)_2$, i.e., $Cu(DPM)_2$, respectively. The source vessels of Bi, Sr, Ca, and Cu among the source vessels $27_1$ to $27_7$ are respectively heated at temperatures of 120°C, 230°C, 200°C, and 150°C. A piping system for the source gas is entirely made of stainless steel and kept at a temperature of about 260°C by a heater not to condensate the source vapor.

The step of manufacturing the BiSrCaCuO oxide thin film will be described below. A crystalline MgO substrate 23 having a (001) orientation is prepared as described above. The surface of the substrate 23 is cleaned by chemical etching, and the substrate is housed in the reaction vessel 21. Thereafter, a high-purity Ar gas is supplied from the Ar gas cylinder 28 into the reaction vessel 21 (in this case, the gas piping is not shown in Fig. 2), and air in the reaction vessel 21 is substituted with the Ar gas. The vacuum pump 26 is operated to adjust a predetermined pressure of the reaction vessel 21 so as to fall within the range of 665 to 10,108 Pa while a pressure is monitored by pressure gauge 25. Thereafter, a high-purity $O_2$ gas is supplied from the $O_2$ gas cylinder 29 to the reaction vessel 21, and the suscepter 22 and substrate 23 are heated to a predetermined temperature within the range of 600°C to 850°C by the electric furnace 24, thereby cleaning the surface of the substrate. Supply of the $O_2$ gas is stopped by rapidly switching the three-way valve $31_8$ to exhaust the $O_2$ gas to an exhaust path, thereby reducing temporary variations in flow rate caused by interruption of the flow pipe. During cleaning of the surface of the substrate, the Ar gas whose flow rate is adjusted is supplied from the Ar gas cylinder 28 through the mass-flow controllers $30_1$ to $30_8$ is supplied to the source vessels 27 of Mg-$(DPM)_2$, $Bi(Ph)3$, $Sr(DPM)_2$, $Ca(DPM)_2$, $Ca(DPM)_2$, and $Cu(DPM)_2$ at a rate of 50 cm³/min. The obtained vapors are supplied to the downstream side through the piping system. In this case, these source gases are discharged to the exhaust path side but not to a reaction vessel side by the three-way valves $31_1$ to $31_7$. The above steps are preliminary steps prior to growth.

The three-way valves $31_1$ to $31_7$ are switched, and the crystalline MgO thin film is deposited as an underlying thin film. The deposition conditions were as follows. The substrate was heated to a temperature of 600°C, and the pressure of the reaction vessel 21 was 1,330 Pa. The flow rate of the $O_2$ gas supplied to the reaction vessel 21 was 50 $cm^3$/min. When the deposition was performed under these conditions for 1 hour, the 1-$\mu$m deposition film could be obtained.

Thereafter, the source gas is sequentially switched to perform crystal growth. A sample formed in the above steps up to the step of forming the underlying thin film was prepared as a test sample. The crystallinity of the underlying thin film was observed by X-ray diffraction and electron diffraction. As a result, the lattice parameter of the underlying thin film was equal to that of the substrate, i.e., a = 4.212 Å. Therefore, it was confirmed that a singlecrystalline thin film was epitaxially grown. Unevenness of the surface of the underlying thin film was measured to be about 50 Å, and the film had excellent flatness.

After deposition of the underlying film, the three-way valves $31_1$ to $31_7$ are switched to discharge a source gas for forming the underlying thin film to the exhaust path, and a source gas for the BiSrCaCuO oxide superconductor thin film is supplied to the reaction vessel 21. At this time, deposition conditions were as follows. The substrate temperature was 600°C, and a pressure of the reaction vessel was 1,330 Pa. The $O_2$ gas was supplied to the reaction vessel at a rate of 50 $cm^3$/min. When the deposition was performed under these conditions for 30 minutes, the 0.5-$\mu$m thin film could be obtained.

It was confirmed by X-ray diffraction that the entire surface of the BiSrCaCuO thin film obtained as described above was singlecrystalline. Lattice parameters were a = 5.4 Å, b = 26 Å, and c = 37 Å. Unevenness of the surface of the thin film was measured to be about 100 Å, and the film had excellent flatness. In addition, no diffusion reaction was found at an interface between the underlying thin film and the oxide superconductor thin film.

The obtained BiSrCaCuO thin film exhibited superconductive characteristics and had a critical temperature of 100 K.

As a comparative example, a BiSrCaCuO thin film was formed under the same conditions as described above except for forming an underlying layer on the crystalline MgO substrate. The 0.5-$\mu$m BiSrCaCuO thin film formed at a substrate temperature of 800°C exhibited superconductive characteristics and had a critical temperature of 65 K. However, the thin film was polycrystalline, and unevenness of its surface was measured to be as large as 1,000 Å.

An example wherein a YBaCuO thin film is formed on a crystalline MgO substrate will be described below.

The same MOCVD device as that used in the first example was used $Y(C_{11}H_{19}O_2)_3$, i.e., Y(DPM)$_3$, $Ba(C_{11}H_{19}O_2)_2$, i.e., Ba(DPM)$_2$, and Cu(DPM)$_2$ were used as organic metal sources for Y, Ba, and Cu, respectively. Source vessels for these organic metal sources were heated to 140°C, 250°C, and 150°C. The same source as in the first example was used as an organic metal source for Mg. A crystalline MgO substrate has an orientation (001), and the crystalline MgO thin film was formed as an underlying thin film in the same preliminary steps as in the first example.

After formation of the underlying thin film, a YBaCuO thin film was deposited by switching three-way valves. Deposition conditions were as follows. The substrate temperature was 600°C, and a pressure of the reaction vessel was 1,330 Pa. The $O_2$ and Ar gases were supplied to the reaction vessel at a rate of 50 $cm^3$/min each. When the deposition was performed under these conditions for 1 hour, the 1-$\mu$m thin film could be obtained.

The YBaCuO thin film obtained in the above manner was observed by X-ray diffraction and electron diffraction. The YBaCuO thin film was epitaxially grown on the crystalline MgO substrate such that the plane (001) of the crystal of the YBaCuO thin film was parallel to the plane (001) of the MgO crystal. It was confirmed that the singlecrystalline YBaCuO thin film was formed on the entire surface. The unevenness of the surface of the YBaCuO thin film was measured to be 50 Å or less, and its flatness was excellent. In this case, a superconductor critical temperature was 89 K.

The present invention is not limited to the above example. For example, when $SrTiO_3$, $LaGaO_3$, $LaAlO_3$ or the like is used as a substrate crystal, a crystalline thin film having the same crystal as the above material is epitaxially grown as an underlying film, and a desired oxide superconductor thin film may be sequentially grown. The present invention can be employed in a BiSrCaCuO thin film to which Pb or Sb is added or in a YBaCuO thin film in which Y is partially substituted with La or the like. The present invention is effective to epitaxially grow not only a superconductor thin film but also a crystalline dielectric oxide thin film such as $BaTiO_3$, $LiNbO_3$, $LiTaO_3$, or $PbTiO_3$.

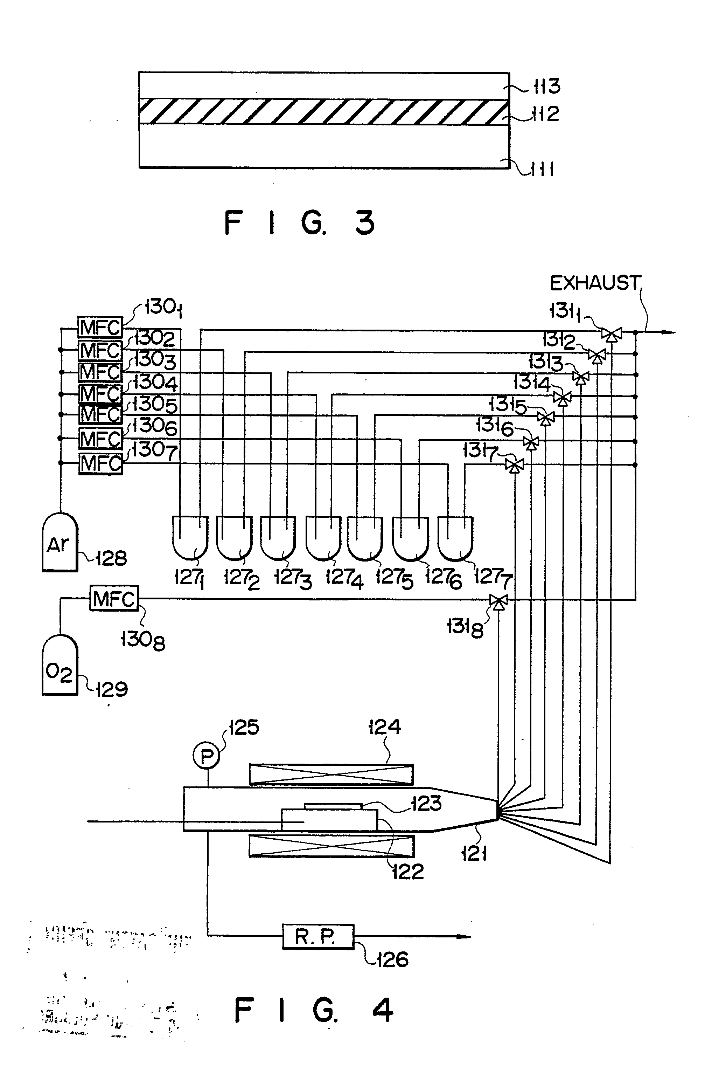

An oxide thin film substrate according to the second example of the present invention will be described below with reference to Fig. 3.

A crystalline $LaGa_xAl_{1-x}O_3$ (0 < x < 1) thin film 112 is formed as an underlying film by MOCVD on a substrate 111 which is a crystalline $LaGaO_3$ substrate, and a BiSrCaCuO oxide semiconducting thin film 113 is then formed on the the film 112.

Fig. 4 shows an MOCVD apparatus used in this example. This device is constituted by a reaction vessel 121 and an electric furnace 124. A substrate 123 is placed on a suscepter 122 in the reaction vessel 121. The suscepter 122 is formed by covering a graphite surface with silicon carbide. Reference numerals 125 and 126 denote a pressure gauge and a vacuum pump, respectively. Organic metal sources are stored in source vessels $127_1$ to $127_7$, and source gases are supplied from the vessels as needed. That is, an Ar gas supplied from an Ar gas cylinder 128 is controlled by mass-flow controllers $130_1$ to $130_7$ and supplied to the source vessels $127_1$ to $127_7$. Thus, the source gases fed from the source vessels $127_1$ to $127_7$ are supplied to the reaction vessel 121 through three-way valves $131_1$ to $131_7$. The flow rate of an $O_2$ gas is controlled by a mass-flow controller $130_8$ to supply the $O_2$ gas to the reaction vessel 121 through an $O_2$ gas cylinder 129 and a three-way valve $131_8$. The mass-flow controllers $130_1$ to $130_8$ and the three-way valve $131_1$ to $131_8$ are controlled by a sequence controller. An opening/closing timing and a holding time for the three-way valves $131_1$ to $131_7$ can be programmed in advance.

$La(C_{11}H_{19}O_2)_3$, i.e., La(DPM)3, $Ga(OC_3H_7)_3$, and $A\ell(OC_3H_7)_3$ are used as organic metal sources for lanthanum (La), gallium (Ga), and aluminum $(A\ell)$. $Bi(Ph)_3$, $Sr(DPM)_2$, $Ca(DPM)_2$, and $Cu(DPM)_2$ are used as organic metal sources for bismuth (Bi), strontium (Sr), calcium (Ca), and copper (Cu), respectively. The source vessels of La, Sr, Ca, and Cu among the source vessels $127_1$ to $127_7$ are respectively heated to temperatures of 120° C, 230° C, 200° C, and 150° C. A piping system for the source gas is entirely made of stainless steel and kept at a temperature of about 260° C by a heater not to condensate the source vapor.

The step of manufacturing the BiSrCaCuO oxide thin film will be described below. A crystalline $LaGaO_3$ substrate 123 having a (001) orientation is prepared as described above. The surface of the substrate 123 is cleaned by chemical etching, and the substrate is loaded in the reaction vessel 121. Thereafter, a high-purity Ar gas is supplied from the Ar gas cylinder 128 into the reaction vessel 121 (in this case, the gas piping is not shown in Fig. 4), and air in the reaction vessel 121 is substituted with the Ar gas. The vacuum pump 126 is operated to adjust a predetermined pressure of the reaction vessel 121 so as to fall within the range of 665 to 10,108 Pa while a pressure is monitored by pressure gauge 125. Thereafter, a high-purity $O_2$ gas is

supplied from the $O_2$ gas cylinder 129 to the reaction vessel 121, and the suscepter 122 and the substrate 123 are heated to a predetermined temperature within the range of 600° C to 850° C by the electric furnace 124, thereby cleaning the surface of the substrate. Supply of the $O_2$ gas is stopped by rapidly switching the three-way valve $131_8$ to exhaust the $O_2$ gas to an exhaust path, thereby reducing temporary variations in flow rate caused by interruption of the flow pipe. During cleaning of the surface of the substrate, the Ar gas whose flow rate is adjusted and which is supplied from the Ar gas cylinder 128 through the mass-flow controller $130_1$ to $130_7$ is supplied to the source vessels $127_1$ to $127_7$ of $La(DPM)_3$, $Ga(OC_3H_7)_3$, $A\ell(OC_3H_7)_3$, $Bi(Ph)_3$, $Sr(DPM)_2$, $Ca(DPM)_2$, and $Cu(DPM)_2$ at a rate of 50 $cm^3$/min each. The obtained vapors are supplied to the downstream side through the piping system. In this case, these source gases are discharged to the exhaust path side but not to a reaction vessel side by the three-way valves $131_1$ to $131_7$. The above steps are preliminary steps prior to growth.

The three-way valves $131_1$ to $131_7$ are switched, and the crystalline $LaGa_{0.94}A\ell_{0.06}O_3$ thin film is deposited as an underlying thin film. The deposition conditions were as follows. The substrate was heated to a temperature of 600° C, and the pressure of the reaction vessel 121 was 1,330 Pa. The flow rate of the $O_2$ gas supplied to the reaction vessel 121 was 50 $cm^3$/min. When the deposition was performed under these conditions for 1 hour, the 1-$\mu$m deposition film could be obtained.

Thereafter, the source gas was switched to grow an oxide superconductor thin film. A sample formed in the above steps up to the step of forming the underlying film was prepared as a test sample, and crystallinity of the obtained underlying thin film was examined by X-ray diffraction and electron diffraction. As a result, lattice parameters were a = 5.39 Å, b = 5.44 Å, and c = 7.69 Å, and it was confirmed that a singlecrystalline thin film was epitaxially grown. Note that lattice parameters of the substrate crystal were a = 5.496 Å, b = 5.524 Å, and c = 7.787 Å. In addition, unevenness of the surface of the underlying thin film was measured to be about 50 Å, and the film had excellent flatness.

After formation of the underlying thin film, the three-way valves $131_1$ to $131_7$ are switched to discharge a source gas for forming the underlying thin film to the exhaust path so as to supply a source gas for the BiSrCaCuO oxide superconductor thin film to the reaction vessel 121. In this case, the deposition conditions were as follows. The substrate temperature was 600° C, and a pressure of the reaction vessel was 1,330 Pa. The $O_2$ gas was

supplied to the reaction vessel at a rate of 50 $cm^3$/min. When the deposition was performed under these conditions for 15 minutes, a 0.3-$\mu$m thin film could be obtained. Note that when a Ga composition x of the underlying thin film falls within the range of $\overline{0.8} \leq x < 1$, the underlying layer can be lattice-matched with the BiSrCaCuO oxide superconductor thin film.

It was confirmed by X-ray diffraction that a single crystal was formed on the entire surface of the BiSrCaCuO thin film obtained in the above manner, and the lattice parameters were a = 5.4 Å, b = 26 Å, and c = 37 Å. The BiSrCaCuO thin film had excellent flatness. In addition, no diffusion reaction was found at an interface between the underlying thin film and the oxide film superconductor thin film.

The BiSrCaCuO thin film exhibited superconductive characteristics and had a critical temperature of 100 K.

When an $LaGa_xA\ell_{1-x}O_3$ underlying thin film and a BiSrCaCuO thin film were sequentially formed as a substrate crystal using an $LaGa_{0.94}A\ell_{0.06}O_3$ in the same manner as described above, an excellent superconductor thin film could be obtained.

As a comparative example, a BiSrCaCuO thin film was formed using a crystalline MgO substrate and a crystalline $SrTiO_3$ substrate without formation of an underlying thin film under conditions substantially similar to the above example. A crystalline layer could be observed at a substrate temperature of 700° C. However, the crystalline layer was polycrystalline and did not exhibit superconductive characteristics. When the substrate temperature was 800° C, the BiSrCaCuO thin film exhibited superconductive characteristics having a critical temperature of 80 K. However, the BiSrCaCuO thin film was polycrystalline, and unevenness of its substrate was measured to be about 1,000 Å. As another comparative example, a BiSrCaCuO thin film was formed using a crystalline $LaGaO_3$ substrate without formation of an underlying thin film. As a result, the BiSrCaCuO thin film exhibited superconductive characteristics having a critical temperature of 90 K when the substrate temperature was 600° C. The thin film had c-axial orientation. However, the thin film was polycrystalline, and unevenness of its surface was measured to be as large as about 300 Å.

The third example wherein a YBaCuO thin film is formed on a crystalline $SrTiO_3$ substrate will be described below.

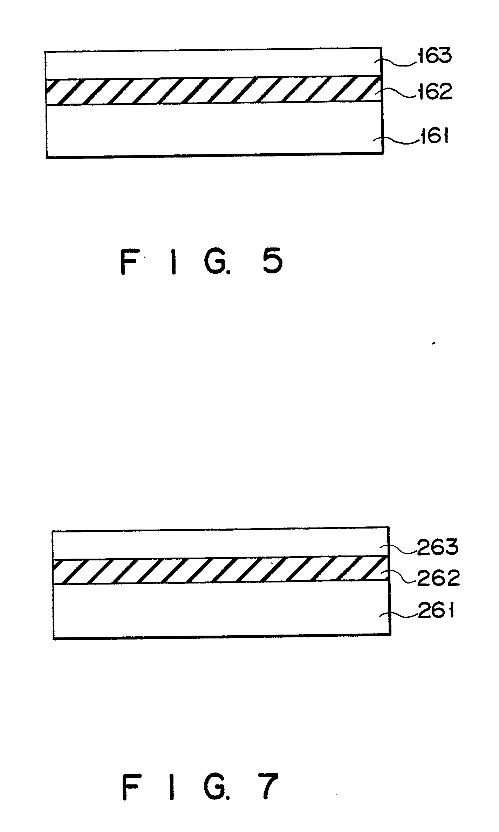

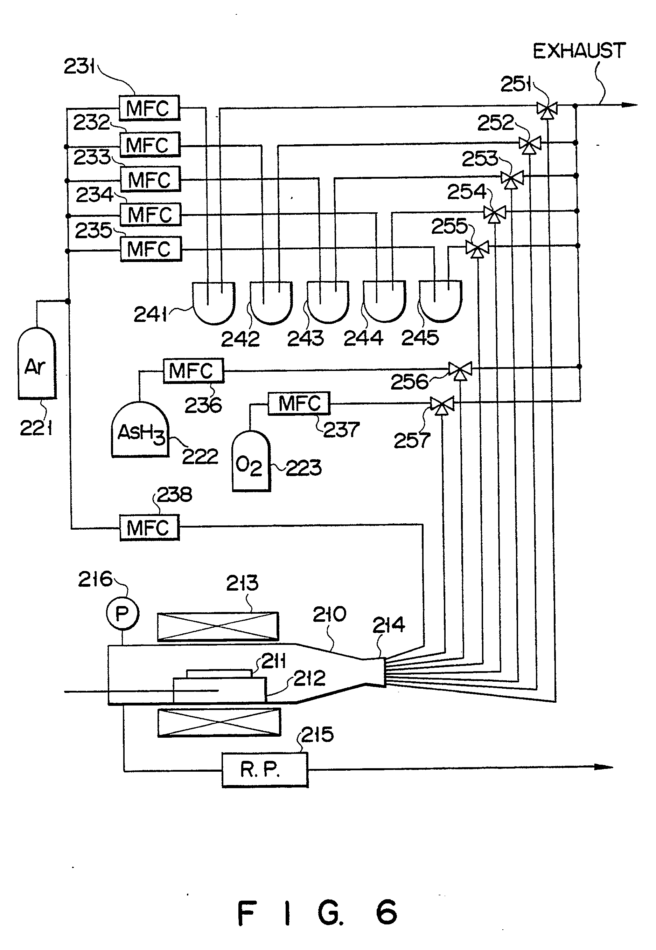

Fig. 5 shows a film structure obtained by this example. Reference numeral 161 denotes a crystalline $SrTiO_3$ substrate. An $LaGa_{0.02}A\ell_{0.98}O_3$ thin film 162 is formed on the substrate 161 as in the above example, and a YBaCuO thin film 163 is formed on the thin film 162.

The same MOCVD apparatus as in the above example was used. $Y(DPM)_3$, $Ba(DPM)_2$, and $Cu(DPM)_2$ were used as organic metal sources for Y, Ba, and Cu, and source vessels for these sources were heated to temperatures of 140° C, 250° C, and 150° C, respectively. As a practical underlying thin film of the third example, a crystalline $LaGa_{0.02}A\ell_{0.98}O_3$ film was used, i.e., x = 0.02. The same organic metal sources for La, Ga, and A$\ell$ as the above example were used. A crystalline $SrTiO_3$ substrate having an orientation (001) was processed in the same preliminary steps as described above, and then a film was formed. Deposition conditions for the underlying thin film were as follows. The substrate was heated to a temperature of 600° C, and the pressure of the reaction vessel was 1,330 pa. The flow rate of the $O_2$ gas supplied to the reaction vessel was 50 $cm^3$/min. When the deposition was performed under these conditions for 1 hour, the 1-$\mu$m deposition film could be obtained. The obtained underlying layer had a single crystal having lattice parameters of a = 3.822 Å, b = 3.843 Å, and c = 5.416 Å. The $LaGa_{0.02}A\ell_{0.98}O_3$ crystal was epitaxially grown such that the (001) plane of the crystal was parallel to the (001) plane of the substrate crystal.

After formation of the underlying thin film, the three-way valves were switched to deposit the YBaCuO thin film. Deposition conditions for the YBaCuO thin film were as follows. The substrate was heated to a temperature of 600° C, and the pressure of the reaction vessel was 1,330 pa. The flow rate of the $O_2$ gas supplied to the reaction vessel was 50 $cm^3$/min. When the deposition was performed under these conditions for 1 hour, the 1-$\mu$m deposition film could be obtained. Note that when a Ga composition x of the underlying thin film falls within the range of $\overline{0} < x \leq 0.1$, the YBaCuO oxide superconductor thin film can be lattice-matched to the BiSrCaCuO oxide superconductor thin film.

The YBaCuO thin film obtained in the above manner was examined by X-ray diffraction and electron diffraction. As a result, the crystal of the YBaCuO thin film was epitaxially grown such that the (001) plane of the crystal was parallel to the (001) plane of the $LaGa_{0.02}A\ell_{0.98}O_3$ film used as the substrate crystal. It was confirmed that the crystal had a single crystal on the entire surface of the substrate. Unevenness of the surface of the substrate was measured to be 50 Å or less and the film had excellent flatness. The substrate had a superconductive critical temperature of 89 K.

The present invention is not limited to the above example. For example, the present invention can be employed to a BiSrCaCuO thin film to which Pb or Sb is added or a YBaCuO thin film in which Y is partially substituted with La or the like.

The composition x of the $LaGa_xAl_{1-x}O_3$ underlying crystal according to the present invention need not to be constant, and the composition can be changed in a direction of growth. For example, in order to grow a YBaCuO superconductor thin film on the MgO substrate, the composition is continuously changed from x = 0.25 to x = 0.02 toward the YBaCuO thin film from the substrate side, and in order to grow the BiSrCaCuO oxide superconductor thin film on an $SrTiO_3$ substrate, the composition is continuously changed from x = 0.25 to x = 0.94. In order to grow a YBaCuO oxide superconductor thin film on an $SrTiO_3$ substrate, the composition is continuously changed from x = 0.07 to x = 0.02, and in order to grow the BiSrCaCuO oxide superconductor thin film, the composition is continuously changed from x = 0.07 to x = 0.94. In case of using $LaGaO_3$ or $LaAlO_3$ as a substrate, the composition of the underlying thin film is changed in a direction of thickness to compensate for differences between lattice parameters of a thin film to be formed and the substrate crystal, thereby obtaining an excellent crystalline thin film.

In addition, a crystalline $LaGa_xAl_{1-x}O_3$ (0 < x < 1) substrate having a composition which can be lattice-matched to a thin film to be formed is used in the present invention, growth of an underlying thin film can be omitted.

The present invention can be employed to growth of oxide films other than a superconductor thin film. More particularly, a composition of an $LaGa_xAl_{1-x}O_3$ crystal is selected according to an oxide thin film epitaxially grown to obtain an oxide thin film having excellent crystallinity.

Fig. 6 is a schematic view showing an epitaxial growth apparatus used in the fourth example of the present invention. Referring to Fig. 6, reference numeral 210 denotes a reaction tube (reaction furnace), and a suscepter 212 for holding a substrate (substrate to be processed) 211 is loaded in the reaction tube 210. The suscepter 212 is formed by covering a graphite surface with silicon carbide (SiC), and a heater 213 such as an infrared lamp for heating the inside of the reaction tube 210 is arranged around the reaction tube 210. An organic metal source gas (to be described later) or the like is supplied into the reaction tube 210 through a gas inlet 214, and the gas in the reaction tube 210 is exhausted through a rotary pump (RP) 215. Note that the temperature of the substrate 211 in the reaction tube 210 is detected by a thermocouple (not shown), and the pressure in the reaction tube 210 is detected by a pressure sensor 216.

Referring to Fig. 6, reference numeral 221 is a high-pressure vessel in which an Ar gas is filled. The Ar gas is supplied to stainless source vessels 241, 242, 243, 244, and 245 through mass-flow controllers 231, 232, 233, 234 and 235 (to be referred to as MFC hereinafter) serving as flow rate controllers. The source vessel 241 is filled with Ca-$(C_5HO_2F_6)_2$ containing fluorine and calcium as an organic metal source for growing a buffer layer, i.e., $Ca(HFA)_2$, $Sr(HFA)_2$ containing fluorine and strontium, or $Ba(HFA)_2$ containing fluorine and barium.

The source vessels 242 to 245 are filled with organic metal sources for growing a BiSrCaCuO high-temperature superconductor. More specifically, $Bi(Ph)_3$, $Sr(DPM)_2$, and $Cu(DPM)_2$ are used as metal organic sources for bismuth (Bi), strontium (Sr), calcium (Ca), and copper (Cu) used for depositing a BiSrCaCuO oxide high-temperature superconductor thin film, respectively. $Bi(Ph)_3$ is stored in the source vessel 242 heated at a temperature of $120^\circ$ C, $Sr(DPM)_2$ is stored in the source vessel 243 heated at a temperature $230^\circ$ C, the $Ca(DPM)_2$ is stored in the source vessel 244 heated at a temperature of $200^\circ$ C, and $Cu(DPM)_2$ is stored in the source vessel 245 heated at a temperature of $150^\circ$ C.

An arsine gas ($AsH_3$) is stored in a high-pressure vessel 222 to supply an As vapor to prevent denaturation of the surface of GaAs during increase in temperature of the substrate 211. A high-pressure vessel 223 is filled with pure oxygen serving as an oxygen source.

When the Ar gas is supplied to the source vessels 241 to 245, vapors of organic metal sources are supplied from the source vessels. These source vapors are supplied in the reaction tube 210 through three-way valves 251 to 255. The flow rate of the $AsH_3$ gas from the high-pressure vessel 222 is controlled by an MFC 236, and then the gas is supplied in the reaction tube 210 through three-way valve 256. The flow rate of the $O_2$ gas from the high-pressure vessel 223 is controlled by an MFC 237, and the $O_2$ gas is supplied in the reaction tube 210 through a three-way valve 257. Note that the flow rate of the Ar gas from the high-pressure vessel 221 is controlled by an MFC 238, and then the Ar gas is directly supplied in the reaction tube 210 through a path other than the above paths.

One path of each of the three-way valves 251 to 257 is connected to the reaction tube 210 as described above, and the other path of each of the three-way valves 251 to 257 is connected to an exhaust pipe (not shown) or the like. The source vessels 241 to 245, the MFCs 231 to 235, and the three-way valves 251 to 255 are connected by pipes and couplings. The MFCs 236 and 237, the three-way valves 256 and 257, and the high-pressure vessels 222 and 223 are connected by pipes and couplings, and the three-way valves 251 to 257 are connected to the gas inlet 214 of the reaction tube 210 by pipes or couplings.

The pipes are made of stainless steel and are heated by a heater (not shown) and kept at a temperature of 260°C to prevent condensation of the organic metal source vapors. The three-way valves 251 to 257 are operated by high-pressure air and entirely controlled by a sequence controller through solenoid valves, and opening/closing timings and holding times of the three-way valves 251 to 257 can be programmed in advance.

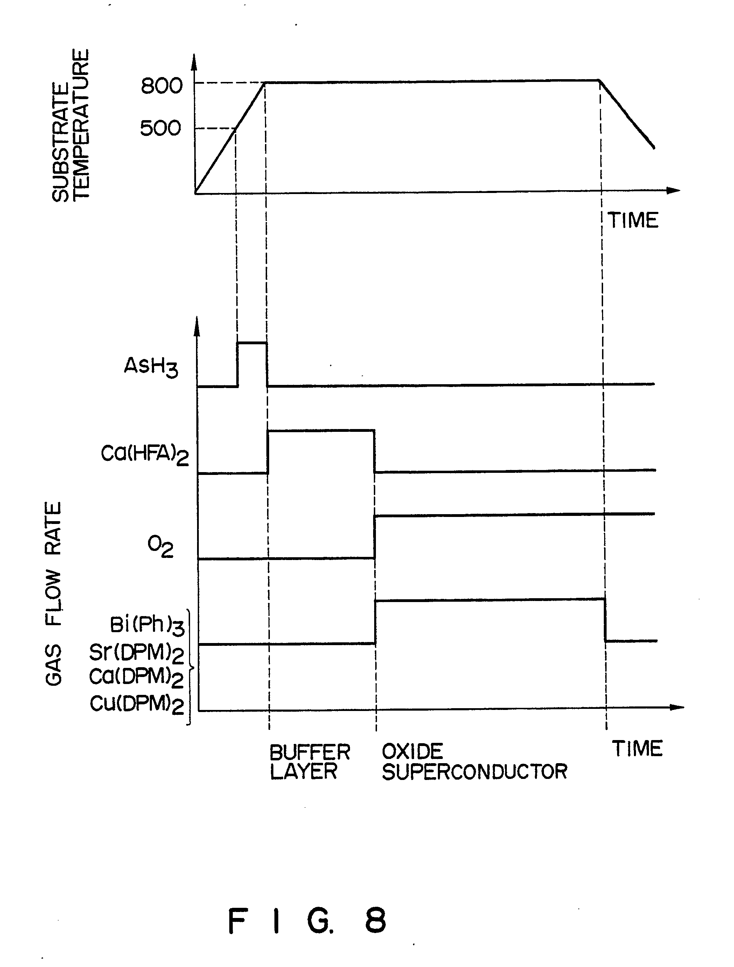

A method of forming a BiSrCaCuO thin film using the above epitaxial growth apparatus according to Example 4 will be described below. In this example, as shown in Fig. 7, GaAs and $CaF_2$ were respectively used to form a substrate 261 and a buffer layer 262. Fig. 8 shows changes in substrate temperature and in flow rate of a gas according to a method of this example.

A GaAs substrate crystal 211 of an orientation (001) whose surface is cleaned by chemical etching is mounted on the above suscepter 212. A high-purity Ar gas is supplied from the high-pressure vessel 221 in the reaction tube 210 through a piping system, and an air in the reaction tube 210 is substituted with the Ar gas. The rotary pump 215 is operated to adjust a predetermined pressure of the reaction tube 210 so as to fall within the range of 665 to 10,108 Pa while a pressure is monitored by pressure gauge 216.

The substrate crystal 211 mounted on the suscepter 212 in the reaction tube 210 is heated by a heater 213. When the substrate temperature reaches 500°C, the high-pressure vessel 222 is opened, and a 10% $AsH_3$ gas diluted with Ar is supplied in the reaction tube 210 at a flow rate of 500 m$\ell$/min adjusted by the MFC 236 upon operation of the three-way valve 256. The $AsH_3$ gas is kept supplied before $CaF_2$ of the buffer layer 262 begins to grow. Thus, evaporation of As from the surface of the GaAs substrate 211 during heating to degrade the surface of the GaAs substrate can be prevented, thereby preventing unevenness of the surface. This heating in the $AsH_3$ gas cannot be omitted to obtain a BiSrCaCuo thin film having a flat surface. Therefore, it was found that, if the heating step was omitted, a flat thin film was not obtained. Note that a gas containing As such as $AsCl_3$, trimethylarsenic (TMAs), and Triethylarsenic (TEAs) can be used instead of $AsH_3$.

The source vessel 241 heated at a temperature of 100°C is opened, and Ar gas is supplied from the high-pressure vessel 221 by the MFC 231 at a flow rate of 50 m$\ell$/min. The obtained $Ca(HFA)_2$ vapor is discharged to an exhaust system by operating the three-way valve 251.

When the substrate temperature reaches 800°C, the $AsH_3$ gas supplied to the reaction tube 210 is supplied to the exhaust system by operating the three-way valve 256. At the same time, the $Ca(HFA)_2$ vapor which was supplied to the exhaust system is supplied in the reaction tube 210 without any loss time by operating the three-way valves 251 and 257 to start growth of $CaF_2$. As an important point in the above step, the surface state of the BiSrCaCuO thin film sensitively depends on a time required for changing gases. This is because, when the $AsH_3$ gas is stopped, the GaAs surface is immediately denatured. As the result of the experiment, it was found that at a temperature of 800°C, the source vapor had to be supplied in the reaction tube 210 within at least 10 seconds after the $AsH_3$ gas in the reaction tube 210 was exhausted. Under the above deposition conditions, a 0.1-$\mu$m $CaF_2$ crystal having a flat surface was deposited on the GaAs substrate 211 within 30 minutes.

Note that, during growth of the $CaF_2$ buffer layer 262, the source vessels 242 to 245 are opened, and the Ar gas supplied from the high-pressure vessel 221 is supplied to the source vessel to adjust the flow rate of the Ar gas by the MFCs 232 to 235. The obtained organic metal vapor is discharged to the exhaust pipe system through the pipe system by operating the three-way valves 252 to 255. At the same time, the high-pressure vessel 223 is opened, and the $O_2$ gas is supplied to the exhaust system by operating the three-way valve 257 such that the flow rate is 500 m$\ell$/min by the MFC 237.

The deposition step for the BiSrCaCuO thin film 263 will be described below. Supply of the $Ca(HFA)_2$ vapor to the reaction tube 210 is stopped to switch the flow of the exhaust system. At the same time, the three-way valves 252 to 255 and 257 are operated to supply $Bi(Ph)_3$, $Sr(DPM)_2$, $Ca(DPM)_2$, $Cu(DPM)_2$, and $O_2$ gases to the reaction tube 210 without any loss time so as to start growth of BiSrCaCuO. At this time, although an influence of time required for switching the valves was not more noticeable than that when the valves were switched from heating of the GaAs substrate 211 to growth of the buffer layer $CaF_2$ 263, if the time required for switching was more than several tens of seconds, it was found that the surface of the grown $CaF_2$ crystal was deteriorated to degrade flatness of the BiSrCaCuO thin film 262 surface which was grown on the $CaF_2$ crystal. The deposition steps of the buffer layer 262 and the BiSrCaCuO thin film 263 must be sequentially continued.

Unevenness of the surface of the high-temperature superconductor oxide thin film 263 obtained by this example is measured to be as small as 200 Å or less, and the surface is flat. Any other crystal than the BiSrCaCuO crystal was not detected by an X-ray diffraction measurement. In addition, it was found that the plane (001) of the BiSrCaCuO crystal was arranged in parallel with the planes (001) of the $CaF_2$ crystal and the GaAs substrate 211 (to be referred to as c-axis orientation), i.e., the BiSrCaCuO crystal was epitaxially grown. When the resistance of the thin film 263 was measured at a low temperature, the thin film 263 exhibited superconductive characteristics, and its critical temperature was 80 K.

On the contrary, a thin film having a thickness of about 8,000 Å was grown at a temperature of 800°C by a conventional method without forming the buffer layer 262. When the obtained thin film was measured by X-ray diffraction, it was found that the thin film was polycrystalline and had a large number of fine crystals oriented on the (100) plane (a-axis orientation) besides c-axis oriented fine crystals compared with the thin film according to this example and that the thin film contained compounds which were not identified besides the BiSrCaCuO crystal. In addition, when the upper and sectional surfaces of the thin film were observed with a microscope, it was found that the grown surface was not flat and that unevenness of the surface was measure to be about 2 $\mu$m or more. When the resistance of the thin film was measured, it was found that the resistance was zero at a temperature of 60 K.

In Example 5, an $SrF_2$ film was grown as the buffer layer 262 instead of the $CaF_2$ film. Basic steps were similar to Example 4, and a source vessel 241 was filled with an $Sr(HFA)_2$ gas and kept at a temperature of 120°C.

As in Example 4, after a GaAs substrate crystal 211 is mounted on a suscepter 212, air in a reaction tube 210 is substituted with Ar. Thereafter, as in Example 4, the substrate crystal 211 is heated, and an $AsH_3$ gas is supplied to the reaction tube 210. The supply of the $AsH_3$ gas is continued before an $SrF_2$ buffer layer is formed. When the temperature of the substrate reaches 800°C, an $Sr(HFA)_2$ vapor is supplied from the source vessel 241 kept at a temperature of 120°C to the reaction tube 210 to grow an $SrF_2$ crystal. After 30 minutes under this condition, a 0.06-$\mu$m $SrF_2$ crystal having a flat surface was grown. The same steps as Example 4 were performed to deposit a BiSrCaCuO thin film 263 on the $SrF_2$ buffer layer 262.

The thin film 263 obtained by this example had a flat surface having unevenness of 280 Å or less. When the thin film 263 was measured by X-ray diffraction, it was found that any crystal except for the BiSrCaCuO crystal was not detected and that the (001) plane of the BiSrCaCuO crystal was arranged in parallel with the (001) plane of the $SrF_2$ crystal and the GaAs substrate crystal 211 (to be referred to as c-axis orientation), i.e., the BiSrCaCuO crystal was epitaxially grown. When the resistance of the thin film 263 at a low temperature was measured, the thin film 263 exhibited superconductive characteristics, and its critical temperature was 75 K.

In Example 6, a $BaF_2$ film was grown as the buffer layer 262 instead of the $CaF_2$ film. Basic steps were similar to Example 4, and a source vessel 241 was filled with a $Ba(HFA)_2$ gas and kept at a temperature of 220°C.

As in example 4, after a GaAs substrate crystal 211 is mounted on a suscepter 212, an air in a reaction tube 210 is substituted with Ar. Thereafter, as in Example 4, the substrate crystal 211 is heated, and an $AsH_3$ gas is supplied to the reaction tube 210. The supply of the $AsH_3$ gas is continued before a $BaF_2$ buffer layer 262 is formed. When the temperature of the substrate reaches 800°C, an $Ba(HFA)_2$ vapor is supplied from the source vessel 241 kept at a temperature of 220°C to the reaction tube 210 to grow a $BaF_2$ crystal. After 1 hour under this condition, a 0.04-$\mu$m $BaF_2$ crystal having a flat surface was grown. The same subsequent steps as in Example 4 were performed to deposit a BiSrCaCuO thin film 263 on the $BaF_2$ buffer layer 262.

The thin film 263 obtained by this example had a flat surface having unevenness of 200 Å or less. When the thin film 263 was measured by X-ray diffraction, it was found that any crystal except for the BiSrCaCuO crystal was not detected and that the (001) plane of the BiSrCaCuO crystal was arranged in parallel with the (001) plane of the $BaF_2$ crystal and the GaAs substrate crystal 211 (to be referred to as c-axis orientation), i.e., the BiSrCaCuO crystal was epitaxially grown. When the resistance of the thin film 263 at a low temperature was measured, the thin film 263 exhibited superconductive characteristics, and its critical temperature was 80 K.

The superconductive characteristics of the thin films 263 obtained by Example 4 to Example 6 are degraded compared with the conventional reports because deposition conditions such as a supply amount of an $O_2$ gas is not optimized. If the supply amount of an $O_2$ gas and the like are optimal, superconductive characteristics almost equal to conventional characteristics can be obtained. As can be apparent from a comparison test of surface flatness of the thin films 263 obtained by Example 4 to Example 6 and the thin film obtained by a prior art, an oxide high-temperature superconductor thin film has a surface flatter than that of the prior art. The flat thin film is necessary for a superconductor junction device. In this respect, Examples 4 to 6 can provide useful thin films compared with conventional techniques.

Example 7 was different from Examples 4 to 6 in that GaP was used as the semiconductor substrate 261 instead of GaAs. Basic steps were similar to those in Example 4. However, since GaP was used to form a substrate, a $PH_3$ gas was used as a source gas before formation of a buffer layer 262 instead of an AsH$_3$ gas.

According to the present invention, as shown in Fig. 8, a high-pressure vessel 322 is used instead of the high-pressure vessel 222, and a PH$_3$ gas is stored in the vessel 322. During an increase in temperature of the substrate, when the substrate temperature reaches 500°C, a 10% PH$_3$ gas diluted with an Ar gas is supplied to the reaction tube 210 at a flow rate of 500 mℓ/min. The PH$_3$ gas is kept supplied until the buffer layer 262 is grown. Therefore, it was prevented that P was evaporated from the surface of the GaP substrate during heating of the substrate to degrade the GaP surface to make the surface uneven. The steps except for this step were the same as in Examples 4 to 6, and a BiSrCaCuO thin film 263 was deposited.

A high-temperature oxide superconductor thin film 263 obtained by this example had a flat surface having unevenness of 200 Å or less. When the thin film 263 was measured by X-ray diffraction, it was found that any crystal except for the BiSrCaCuO crystal was not detected and that the (001) plane of the BiSrCaCuO crystal was arranged in parallel with the (001) plane of the GaP substrate crystal and a CaF$_2$ (BaF$_2$ or SrF$_2$) crystal (to be referred to as c-axis orientation), i.e., the BiSrCaCuO crystal was epitaxially grown. When the resistance of the thin film 263 at a low temperature was measured, the thin film 263 exhibited superconductive characteristics, and its critical temperature was 60 K.

According to the present invention, although GaP is used as the substrate 261, InP can be used in place of GaP. In addition, a gas containing phosphorus can be used instead of the PH$_3$ gas.

On the contrary, a thin film having a thickness of about 8,000 Å was grown at a temperature of 800°C by a conventional method without forming the buffer layer 262. When the obtained thin film was measured by X-ray diffraction, it was found that the thin film was polycrystalline and had a large number of fine crystals oriented on the (100) plane (a-axis orientation) besides c-axis orientation fine crystals compared with the thin film according to this example and that the thin film contained compounds which were not identified besides the BiSrCaCuO crystal. In addition, when the upper and sectional surfaces of the thin film were observed with a microscope, it was that the grown surface was not flat and unevenness of the surface was about 2000 Å or more. When the resistance of the thin film was measured, it was found that the resistance was zero at a temperature of 35 K.

Example 8 was different from Examples 4 to 6 in that Si was used as the semiconductor substrate 261 instead of GaAs. Basic steps are similar to those in Example 4. However, since Si was used as the substrate, an AsH$_3$ gas was used as a source gas before formation of a buffer layer 262 instead of an AsH$_3$ gas.

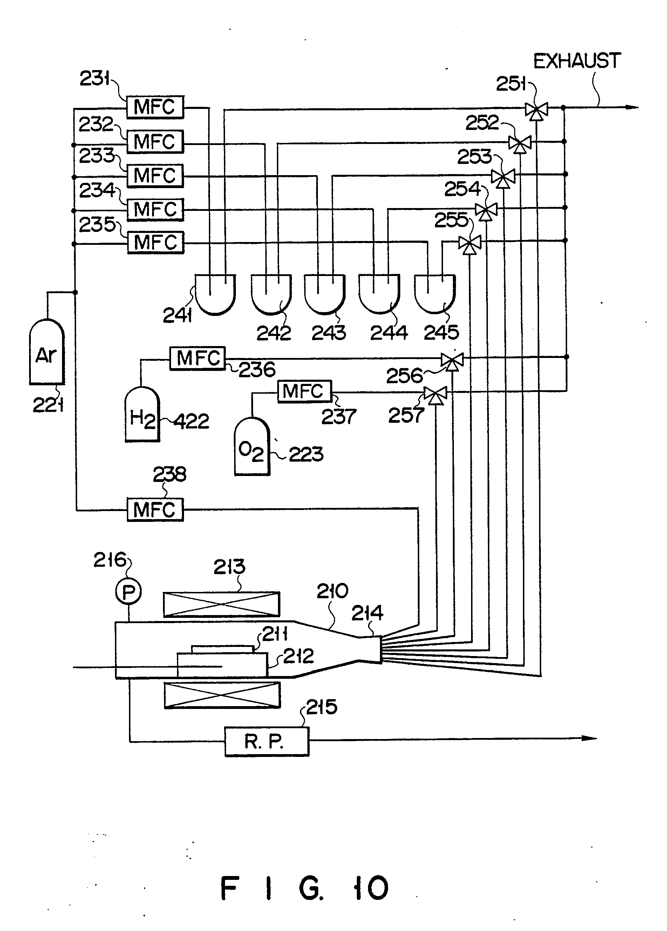

According to this example, as shown in Fig. 10, a high-pressure vessel 422 is used instead of the high-pressure vessel 222, and an H$_2$ gas is stored in the vessel 422. During an increase in temperature of the substrate, when the substrate temperature reaches 500°C, the high-pressure vessel 422 is opened to supply the H$_2$ gas to the reaction tube 210 at a flow rate of 500 mℓ/min. The substrate is heated to a temperature of 900°C by controlling a heater 213 to reduce a natural oxide film, thereby obtaining a clean Si surface. Thereafter, after the temperature of the Si substrate is decreased to 800°C, a fluoride buffer layer 262 is deposited as in Examples 4 to 6. Note that the H$_2$ gas is kept supplied until the buffer layer 262 is grown. Thus, formation of an oxide film on the Si substrate surface again by a small amount of oxygen contained in the Ar gas during heating the substrate can be prevented, thereby keeping flatness of the Si substrate surface.

When the substrate temperature reaches 800°C, the H$_2$ gas supplied to the reaction tube 210 is supplied to the exhaust system by operating the three-way valve 256. At the same time, the Ca(HFA)$_2$ and Sr(HFA)$_2$ or Ba(HFA)$_2$ vapor which was supplied to the exhaust system is supplied to the reaction tube 210 without any loss time by operating the three-way valves 251 and 257 to start growth of CaF$_2$, SrF$_2$ or BaF$_2$. As an important point in the above step, the surface state of the BiSrCaCuO thin film sensitively depends on a time required for changing gases. This is because, when the AsH$_3$ gas is stopped, the GaAs surface is immediately denatured.

As results of the experiment, it was found that at a temperature of 800°C, the source vapors for a buffer layer and the O$_2$ gas had to be supplied in the reaction tube 210 within at least 10 seconds after the H$_2$ gas in the reaction tube 210 was exhausted. Under the above deposition condition, a 0.1-µm CaF$_2$ and SrF$_2$ or BaF$_2$ crystal having a flat surface was deposited on the Si substrate within 30 minutes. The following steps were the same as those in Example 4, and the BiSrCaCuO thin film 263 was formed.

A high-temperature oxide superconductor thin film 263 obtained by this example had a flat surface having unevenness of 100 Å or less. When the thin film 263 was measured by X-ray diffraction, it was found that any crystal except for the BiSrCaCuO crystal was not detected and that the (001) plane of the BiSrCaCuO crystal was arranged in parallel with the (001) plane of the Si substrate crystal and the crystal (to be referred to as c-axis orientation), i.e., the BiSrCaCuO crystal was epitaxially grown. When the resistance of the thin film 263 at a low temperature was measured, the thin film 263 exhibited superconductive characteristics, and its critical temperature was 80 K.

Contrast to this, a BiSrCaCuO thin film formed by a conventional method without forming the fluoride buffer layer 262 between the Si substrate and the BiSrCaCuO thin film did not exhibit superconductive characteristics, and the thin film surface was observed as a matted surface by naked eyes. When the sectional view of the thin film was observed with a microscope, unevenness of the surface was measured to be 1000 Å or more. In addition, a 0.1-$\mu$m $CaF_2$ buffer layer was deposited on the Si substrate by vacuum deposition, and a BiSrCaCuO thin film was deposited by MOCVD under the same conditions as the $CaF_2$ buffer layer. The BiSrCaCuO thin film exhibited superconductive characteristics, and its critical temperature was the same temperature (78 K) as in this example. Although unevenness of the BiSrCaCuO thin film surface was as small as 200 Å, there are a lot of fine projections such as a precipitate on the surface. Therefore, flatness of the thin film was degraded compared with this example. This is because in the conventional method, after the $CaF_2$ thin film is deposited on the Si substrate by vacuum deposition, the $CaF_2$ surface is contaminated while the substrate is removed from a vacuum device and then inserted into an epitaxial growth device.

The present invention is not limited to the above described examples. In the above examples, pure compounds such as $CaF_2$, $BaF_2$, and $SrF_2$ are used as metal fluorides for forming the buffer layers 262. Instead of the compounds, alloys of these compounds, i.e., mixed crystals can be used, thereby obtaining a crystal layer having uniform lattice parameters which cannot be exhibited by the above three types of fluoride crystals. In addition, a buffer layer 262 having chemical properties which are different from those of a pure crystal can be prepared. More specifically, although an HFA organic compound of one metal element is stored in the source vessel for depositing the fluoride buffer layer 262 in the examples, two or three types of organic metal sources are simultaneously in the source vessel. Since $Ca(HFA)_2$, $Sr(HFA)_2$, and $Ba(HFA)_2$ respectively exhibit difference vapor pressures in response to temperatures, concentrations of vapors of $Ca(HFA)_2$, $Sr(HFA)_2$, and $Ba(HFA)_2$ supplied to a reaction furnace can be relatively changed by changing a temperature of the source vessel. Thus, $Ca_xSr_yBa_{1-x-y}F_2$ mixed crystal buffer layers 262 having different compositions can be obtained.

In order to control the mixed crystal composition of the buffer layer in a wide range, three source vessels are used instead of one source vessel for depositing the fluoride buffer layer 262. $Ca(HFA)_2$, $Sr(HFA)_2$, and $Ba(HFA)_2$ are stored in the three source vessels, respectively, and concentrations of $Ca(HFA)_2$, $Sr(HFA)_2$, and $Ba(HFA)_2$ vapors supplied to the reaction furnace are independently controlled by controlling the heating temperatures of the source vessels. As a result, a $Ca_xSr_yBa_{1-x-y}F_2$ mixed crystal buffer layer 262 having any composition can be obtained.

The above description is the modification associated with formation of the mixed buffer layer 262, and a multilayered buffer consists of two or more layers can be used as a buffer layer 262. For example, a $CaF_2/SrF_2$ two-layered buffer layer or a $CaF_2/SrF_2/BaF_2$ three-layered buffer layer can be formed by changing the order of $Ca(HFA)_2$, $Sr(HFA)_2$, and $Ba(HFA)_2$ vapors supplied to the reaction furnace. In addition, multilayered buffer layers 262 having different layer structures can be formed by changing the order of the vapors supplied to the reaction furnace. Thus, for example, a preferred fluoride crystal can be deposited on the GaAs substrate, and a preferable fluoride crystal can be finally deposited on the BiSrCaCuO crystal.

The present invention is not limited to the high-temperature BiSrCaCuO oxide superconductive thin film. The present invention can be applied to formation of a YBaCuO high-temperature oxide superconductor thin film. Organic metal sources or $O_2$ serving as an oxidant are not limited to those in the examples, and other sources may be equally used to obtain the same effects as in the above examples in accordance with the principle of the present invention. That is, other metals may be used in the present invention. The effect of present invention is not limited to superconductor oxides. When a proper nonoxide crystal is used to form a buffer layer, the present invention can be applied to a general MOCVD for an oxide such a ferroelectric oxide (e.g., $LiNbO_3$, $BaTiO_3$, $PbTiO_3$, etc.).

## Claims

1. A method of epitaxially growing a crystalline oxide thin film, comprising the steps of:

loading a substrate (11, 23) in a reaction vessel (21);

epitaxially growing as an underlying film a crystalline thin film (12) essentially consisting of the same material as that of said substrate on said substrate; and

changing a source gas to epitaxially grow a desired crystalline oxide thin film (13) on said underlying film.

2. A method of epitaxially growing a crystalline oxide thin film, comprising the steps of:

loading a substrate (111, 112, 123, 161, 162), at least a surface portion of which essentially consists of an LaGa$_x$Aℓ$_{1-x}$O$_3$ (0 < x < 1) crystal, in a reaction vessel (121), and

epitaxially growing a YBaCuO or BiSrCaCuO oxide thin film (113, 163) on said substrate.

3. A method of epitaxially growing a crystalline oxide thin film, comprising the steps of:

loading a substrate (111, 123, 161) in a reaction vessel;

epitaxially growing an LaGa$_x$Aℓ$_{1-x}$O$_3$ (0 < x < 1) (112, 162) as an underlying film on said substrate; and

changing a source gas to epitaxially grow a YBaCuO or BiSrCaCuO oxide thin film (113, 163).

4. A method of epitaxially growing a crystalline oxide thin film, comprising the steps of:

loading a GaAs substrate (211, 261) in a reaction furnace (214);

heating said GaAs substrate to a temperature for depositing an oxide thin film while a gas (222) containing arsenic is supplied to said reaction furnace;

supplying an organic metal compound source gas containing fluorine and a metal element to said reaction furnace immediately after supply of the gas containing arsenic is stopped, and depositing a buffer layer (262) essentially consisting of a metal fluoride thin film crystal on said GaAs substrate; and

supplying a gas containing oxygen and an organic metal compound source gas containing a metal element for a desired oxide thin film to be formed in said reaction furnace and depositing said desired oxide thin film (263) on said buffer layer.

5. A method of epitaxially growing a crystalline oxide thin film, comprising the steps of:

loading a GaP or InP substrate (211, 261) in a reaction furnace (214);

heating said substrate to a temperature for depositing an oxide thin film while a gas (322) containing phosphorus is supplied to said reaction furnace;

supplying an organic metal compound source gas containing fluorine and a metal element to said reaction furnace immediately after supply of the gas containing phosphorus is stopped, and depositing a buffer layer (262) essentially consisting of a metal fluoride thin film crystal on said substrate; and

supplying a gas containing oxygen and an organic metal compound source gas containing a metal element for a desired oxide thin film to be formed to said reaction furnace, and depositing said desired oxide thin film (263) on said buffer layer.

6. A method of epitaxially growing a crystalline oxide thin film, comprising the steps of:

loading an Si substrate (211, 261) in a reaction furnace (214);

heating said Si substrate to a temperature or more to deposit a metal fluoride while a gas (422) containing the hydrogen is supplied to said reaction furnace;

supplying an organic metal compound source gas containing fluorine and a metal element to said reaction furnace immediately after supply of the gas containing hydrogen is stopped, and depositing a buffer layer (262) essentially consisting of a metal fluoride thin film crystal on said Si substrate; and

supplying a gas containing oxygen and an organic metal compound source gas containing a metal element for a desired oxide thin film to be formed to said reaction furnace, and depositing said desired oxide thin film (263) on said buffer layer.

7. A method according to any one of claims 3 to 5, characterized in that said desired oxide thin film (263) essentially consists of a high-temperature superconductor.

8. A method according to any one of claims 3 to 6, characterized in that said buffer layer (262) comprises a single layer essentially consisting of one compound selected from the group consisting of CaF$_2$, SrF$_2$, and BaF$_2$, or a multi-layered film essentially consisting of at least two compounds selected from the group consisting of CaF$_2$, SrF$_2$, and BaF$_2$.

9. A method according to any one of claims 3 to 6, characterized in that said buffer layer (262) essentially consists of a mixed crystal material made of at least two elements selected from the group consisting of Ca, Sr, and Ba.

10. An oxide thin film base comprising:

a substrate (11);

a crystalline thin film (12) epitaxially grown on said substrate and essentially consisting of the same material as that of said substrate; and

a crystalline oxide thin film (13) formed on said crystal thin film.

11. An oxide thin film base comprising:

a substrate (111, 112, 161, 162), at least a surface portion of which essentially consists of an LaGa$_x$Aℓ$_{1-x}$O$_3$ (0 < x < 1) crystal; and

a YBaCuO or BaSrCaCuO oxide thin film (113, 163) formed on said substrate.

12. A base according to claim 11, characterized in that said substrate has an LaGa$_x$Aℓ$_{1-x}$O$_3$ (0 < x < 1) film epitaxially grown on a surface of said substrate.

13. An oxide thin film base comprising:

a semiconductor substrate (261);

a buffer layer (262) epitaxially grown on said semiconductor substrate (261), said buffer layer essentially consisting of a fluoride thin film crystal; and

an oxide thin film (263) formed on said buffer layer.

14. A base according to claim 13, characterized in that said oxide thin film (263) essentially consists of a high-temperature superconductor.

15. A method of epitaxially growing a crystalline oxide thin film, comprising the steps of:

loading a semiconductor substrate (211, 261) in a reaction furnace (214);

heating said semiconductor substrate to a temperature for depositing an oxide thin film while a gas (222, 322, 422) for preventing degradation of a surface of said semiconductor substrate is supplied to said reaction furnace;

supplying an organic metal compound source gas containing fluorine and a metal element to said reaction furnace immediately after supply of the gas is stopped, and depositing a buffer layer (262) essentially consisting of a metal fluoride thin film crystal on said semiconductor substrate; and

supplying a gas containing oxygen and an organic metal compound source gas containing a metal element for a desired oxide thin film to be formed to said reaction furnace, and depositing said desired oxide thin film (263) on said buffer layer.

F I G. 1

F I G. 2

# F I G. 3

# F I G. 4

163

162

161

# F I G. 5

263

262

261

# F I G. 7

F I G. 6

F I G. 8

F I G. 9

F I G. 10